# EUROPEAN PATENT SPECIFICATION

(11) **EP 1 577 934 B1**
(45) Date of publication and mention of the grant of the patent: **08.08.2007**
(21) Application number: 05005599.5
(22) Date of filing: 15.03.2005
(51) Int. Cl.: H01L 21/306, C11D 11/00, C11D 7/26, C11D 7/32, C11D 3/33, C11D 3/20, C11D 3/30

(54) **Alkaline post-chemical mechanical planarization cleaning compositions**
Alkalische Reinigungsmittel zur Reinigung nach einer chemisch-mechanischen Planarisierung
Compositions nettoyantes pour nettoyage suivant une planarisation chémico-mécanique

(30) Priority: 19.03.2004 US 554638 P; 25.02.2005 US 65080 P
(43) Date of publication of application: 21.09.2005
(73) Proprietor: AIR PRODUCTS AND CHEMICALS, INC., Allentown, PA 18195-1501 (US)
(72) Inventor: Chandrakant Tamboli, Dnyanesh, Breinigsville, PA 18031 (US); Banerjee, Gautam, Chandler, AZ 85224 (US)
(74) Representative: Kador & Partner

(56) References cited:
- EP-A- 0 678 571
- WO-A-02/065538
- US-A1- 2001 018 407
- US-A1- 2003 083 214
- US-A1- 2003 207 778
- US-B1- 6 534 458
- TUNG MING PAN ET AL: "COMPARISON OF NOVEL CLEANING SOLUTIONS WITH VARIOUS CHELATING AGENTS FOR POST-CMP CLEANING ON POLY-SI FILM" November 2001 (2001-11), IEEE TRANSACTIONS ON SEMICONDUCTOR MANUFACTURING, IEEE INC, NEW YORK, US, PAGE(S) 365-371 , XP001102403 ISSN: 0894-6507 * page 365, right-hand column, last paragraph * * page 366, left-hand column, paragraphs 1,2 * * page 368, left-hand column *
- FRASER B ET AL: "NONCONTACT MEGASONICS FOR POST-CU CMP CLEANING" SOLID STATE TECHNOLOGY, COWAN PUBL.CORP. PORT WASHINGTON, NY, US, vol. 43, no. 7, July 2000 (2000-07), pages 105-106,110,11, XP000936443 ISSN: 0038-111X

## Description

### CROSS-REFERENCE TO RELATED APPLICATIONS

This application claims the benefit of U.S. Provisional Application No. 60/554,638, filed 19 March 2004.

### BACKGROUND OF THE INVENTION

In the semiconductor industry, copper interconnects are increasingly being used as an interconnect material rather than aluminum. The superior electrical conductivity of copper over aluminum may result in higher speed interconnections of greater current carrying capability. Currently, copper interconnects are formed using a so-called "damascene" or "dual-damascene" fabrication process. Briefly, a damascene metallization process forms interconnects by the deposition of conducting metals in recesses formed on a semiconductor wafer surface. Typically, semiconductor devices (e.g., integrated circuits) are formed on a semiconductor substrate. These substrates are generally covered with an oxide layer. Material may be removed from selected regions of the oxide layer creating openings referred to as in-laid regions within the substrate surface. These in-laid regions correspond to a circuit interconnect pattern forming the conductor wiring of the device.

Once the in-laid pattern has been formed within the oxide layer, a thin barrier layer may be fabricated that evenly blankets the patterned oxide layer. This barrier layer may composed of, but is not limited to, titanium nitride, tantalum nitride, or tungsten nitride. After the barrier layer is formed, a seed layer of a conductive metal, preferably comprising copper, is deposited. The seed layer of copper forms the foundation for the bulk deposition of copper by a variety of deposition techniques including, but not limited to, physical sputtering, chemical vapor deposition (CVD), or electroplating. After the bulk copper has been deposited, excess copper may be removed using, for example, by chemical-mechanical polishing (CMP). Besides removing excess material, the CMP process adds in achieving planarity of the substrate surface. CMP of copper layers are particularly challenging due to the fact that the copper, the underlying substrate material, and the diffusion barrier material are removed at different rates. This problem is often referred to as "selectivity". Other problems associated with CMP processes, particularly with copper layers, include, but are not limited to, copper dishing, oxide erosion, and/or field loss.

In CMP processes, polishing and removal of excess material is accomplished through a combination of chemical and mechanical means. The CMP process involves the application of a CMP slurry containing abrasive particles (e.g., alumina, silica, ceramic, polymeric particles, etc.) within a chemically reactive medium to a substrate surface. In a typical CMP process, a wafer surface may be mechanically scrubbed via a polishing pad while a chemically reactive slurry containing abrasive particles flows over the surface. In yet another CMP process referred to as "fixed abrasive CMP", abrasive particles may be embedded within the surface of the polishing pad while the surface of the wafer is contacted with chemically reactive medium.

A typical CMP slurry is an aqueous suspension comprised of abrasive particles, reactive agents, surfactants, and a suitable oxidizing agent. Reactive agents that may added to slurries include organic acids (e.g. citric acid), amino acids (e.g., glycine) and azoles (e.g., benzotriazoles). Unfortunately, CMP processing leaves behind residues such as particles, films, metal ion impurities and oxides that are generated from the slurry or by the process itself. Some or the reactive agents used in certain CMP slurries may also leave residues and provide a potential source of corrosion. For example, the use of abrasive particles within the CMP slurries may cause various particulate contaminants to remain on the polished surface. Further, certain reactive agents such as benzotriazole may leave an organic residue or film on the substrate surface. Other reactive agents such as certain salts such as sodium, potassium, and iron salts and/or compounds in slurry formulations may leave behind significant amounts of these metal ion impurities. Additionally, reactive agents such as oxidizers may leave a residual oxide layer on the copper due to oxidization of the copper during the CMP process. This residual oxide layer may adversely affect the electrical characteristics of the an electronic device.

To remedy these problems, a post-CMP cleaning step may be needed to remove the residues described above while limiting corrosion to the underlying substrate surface. Additional goals of the post-CMP cleaning step include, but are not limited to prevention of watermarks on low dielectric constant (low-k) surfaces. Advanced low-k dielectric surfaces used for semiconductor fabrication are hydrophobic in nature and tend to form watermarks during the wafer drying. Cleaning chemistries also need to minimize water-mark formation by improving the wettability of the wafer towards the cleaning chemistry. The post-CMP cleaning step should meet these goals while minimize the etching of the substrate surface and avoiding increased surface roughness to any significant extent.

### BRIEF SUMMARY OF THE INVENTION

Disclosed herein is a post-CMP cleaning composition and a method comprising same. In one embodiment, there is provided a composition to treat a substrate after chemical mechanical planarization comprising: water, an organic base, a plurality of chelating agents comprised of an amino polycarboxylic acid and a hydroxycarboxylic acid, optionally a surfactant, and optionally a corrosion inhibitor wherein the pH of the composition ranges from 9.5 to 11.5.

### BRIEF DESCRIPTION OF SEVERAL VIEWS OF THE DRAWINGS

Figure 1 compares the capacitance versus time for some exemplary compositions described herein.

Figure 2 provides a comparison of impedance curves for some exemplary solutions of the present invention.

Figure 3 provides the X-ray induced Auger electron peaks for an as polished and as-polished + solution treated sample.

### DETAILED DESCRIPTION OF THE INVENTION

A post-CMP cleaning composition and method comprising same are disclosed herein. The composition and method described herein may be used to remove residues generated from the CMP cleaning process. In certain embodiments, the substrate contains copper or copper-containing materials. The terms "copper" and "copper-containing materials" are used interchangeably herein and includes, but is not limited to, substrates comprising layers of pure copper, copper-containing alloys such as Cu-Al alloys, and Ti/TiN/Cu, and Ta/TaN/Cu multi-layer substrates. In these embodiments, the composition, despite being formulated in an alkaline pH range, unexpectedly and surprisingly does not cause oxidation of copper surface. Further, the composition may also chelate metal ions and clean various substrates such as, for example, semiconductor wafers after treatment with same.

The cleaning composition comprises water, an organic base, a plurality of chelating agents, optionally a surfactant, and optionally a corrosion inhibitor. The plurality of chelating agents is comprised of at least one amino polycarboxylic acid and at least one hydroxy carboxylic acid. The pH of the composition may ranges from 9.5 to 11.5 or from 10 and 11.

The composition described herein includes an organic base. The amount of organic base added to the composition should be sufficient to obtain a pH of at least 9.5. The organic base does not cause corrosion to the underlying substrate, particularly copper. In certain preferred embodiments, the organic base comprises a quaternary ammonium hydroxide. Specific examples of quaternary ammonium hydroxides include tetramethylammonium hydroxide (TMAH), tetraethylammonium hydroxide, tetrapropylammonium hydroxide, trimethylethylammonium hydroxide, (2-hydroxyethyl)trimethylammonium hydroxide, (2-hydroxyethyl)triethylammonium hydroxide, (2-hydroxyethyl)tripropylammonium hydroxide and (1-hydroxypropyl)trimethylammonium hydroxide. In one particular embodiment, the composition contains a quaternary ammonium hydroxide such as TMAH. Examples of other suitable organic bases besides quaternary ammonium hydroxides include, but are not limited, hydroxylamines, organic amines such as primary, secondary or tertiary aliphatic amines, alicyclic amines, aromatic amines and heterocyclic amines, and aqueous ammonia. Specific examples of the hydroxylamines include hydroxylamine (NH₂OH), N-methylhydroxylamine, N,N-dimethylhydroxylamine and N,N-diethylhydroxylamine. Specific examples of the primary aliphatic amines include monoethanolamine, ethylenediamine and 2-(2-aminoethylamino)ethanol. Specific examples of the secondary aliphatic amines include diethanolamine, N-methylaminoethanol, dipropylamine and 2-ethylaminoethanol. Specific examples of the tertiary aliphatic amines include dimethylaminoethanol and ethyldiethanolamine. Specific examples of the alicyclic amines include cyclohexylamine and dicyclohexylamine. Specific examples of the aromatic amines include benzylamine, dibenzylamine and N-methylbenzylamine. Specific examples of the heterocyclic amines include pyrrole, pyrrolidine, pyrrolidone, pyridine, morpholine, pyrazine, piperidine, N-hydroxyethylpiperidine, oxazole and thiazole. The organic bases may be used either alone or in combination with one another.

Since a chelating agent may be more selective with regard to one metal ion over another, a plurality of chelating agents or salts thereof are used in the compositions described herein. It is believed that these chelating agents may bind to metal ion contaminants on the substrate surface and dissolve them into the composition. Further, in certain embodiments, the chelating agent should be able to retain these metal ions in the composition and prevent the ions from re-depositing on the substrate surface. In certain embodiments, the chelating agent added to the composition may have antioxidant properties that may also prevent oxidation of copper surface at an alkaline pH.

The concentration of total chelating agent added to the composition may range from 50 parts per million (ppm) to 15% or from 0.1 % to 5% by weight. Examples of suitable chelating agents that may be used include, but are not limited to: ethylenediaminetetracetic acid (EDTA), N-hydroxyethylethylenediaminetriacetic acid (NHEDTA), nitrilotriacetic acid (NTA), diethylklenetriaminepentacetic acid (DPTA), ethanoldiglycinate, citric acid, gluconic acid, oxalic acid, phosphoric acid, tartaric acid, methyldiphosphonic acid, aminotrismethylenephosphonic acid, ethylidene-diphosphonic acid, 1-hydroxyethylidene-1,1-diphosphonic acid, 1-hydroxypropylidene-1,1-diphosphonic acid, ethylaminobismethylenephosphonic acid, dodecylaminobismethylenephosphonic acid, nitrilotrismethylenephosphonic acid, ethylenediaminebismethylenephosphonic acid, ethylenediaminetetrakismethylenephosphonic acid, hexadiaminetetrakismethylenephosphonic acid, diethylenetriaminepentamethylenephosphonic acid and 1,2-propanediaminetetetamethylenephosphonic acid or ammonium salts, organic amine salts, malonic acid, succinic acid, dimercapto succinic acid, glutaric acid, maleic acid, phthalic acid, fumaric acid, polycarboxylic acids such as tricarbaryl acid, propane-1,1,2,3-tetracarboxylic acid, butane-1 ,2,3,4-tetracarboxylic acid, pyromellitic acid, oxycarboxylic acids such as glycolic acid, β-hydroxypropionic acid, citric acid, malic acid, tartaric acid, pyruvic acid, diglycol acid, salicylic acid, gallic acid, polyphenols such as catechol, pyrogallol, phosphoric acids such as pyrophosphoric acid, polyphosphoric acid, heterocyclic compounds such as 8-oxyquinoline, diketones such as α-dipyridyl acetylacetone.

The plurality of chelating agents comprises an amino polycarboxylic acid and a hydroxyl carboxylic acid. Amino polycarboxylic acids may, for example, chelate metal ions within the composition. However the chelating ability of these amino-polycarboxylic acids may be diminished at alkaline pH thereby reducing the effectiveness of the composition. To remedy this, a hydroxycarboxylic acid is added to improve cleaning performance at the particular pH levels. Examples of suitable amino polycarboxylic acids include ethylene diamine tetra acetic acid (EDTA), n-hydroxy ethylene diamine triacetic acid (HEDTA), diethylene triamine pentaacetic acid (DTPA) and nitrilo triacetic acid (NTA). Examples of hydroxyl carboxylic acids include citric acid, gluconic acid, malic acid, tartaric acid, lactic acid. In one particular embodiment, three different chelating agents: the amino polycarboxylic acid EDTA and the hydroxyl carboxylic acids gluconic acid and citric acid are used.

Water is also present in the composition disclosed herein. It can be present incidentally as a component of other elements, such as for example, an aqueous based organic base solution or chelating solution, or it can be added separately. Some nonlimiting examples of water include deionized water, ultra pure water, distilled water, doubly distilled water, or deionized water having a low metal content. Preferably, water is present in amounts of about 65 % by weight or greater, or about 75% by weight or greater, or about 85% by weight or greater, or about 95% by weight or greater.

Surfactant may be optionally added to the composition. Any type of surfactant anionic/cationic/non-ionic/zwitterionic or combinations thereof may be used. The choice of surfactant may depend upon various criteria including wetting properties, foaming properties, detergency, rinsability, etc. In these embodiments, surfactant concentration may range from 1 ppm to 10000 ppm or from 50 ppm to 5000 ppm. Further examples of surfactants include silicone surfactants, poly(alkylene oxide) surfactants, and fluorochemical surfactants. Suitable non-ionic surfactants for use in the process composition include, but are not limited to, octyl and nonyl phenol ethoxylates such as TRITON® X-114, X-102, X-45, X-15 and alcohol ethoxylates such as BRIJ® 56 (C₁₆H₃₃(OCH₂CH₂)₁₀OH) (ICI), BRIJ® 58 (C₁₆H₃₃(OCH₂CH₂)₂₀OH) (ICI). Still further exemplary surfactants include acetylenic alcohols and derivatives thereof, acetylenic diols (non-ionic alkoxylated and/or self-emulsifiable acetylenic diol surfactants) and derivatives thereof, alcohol (primary and secondary) ethoxylates, amine ethoxylates, glucosides, glucamides, polyethylene glycols, poly(ethylene glycol-co-propylene glycol), or other surfactants provided in the reference *McCutcheon's Emulsifiers and Detergents,* North American Edition for the Year 2000 published by Manufacturers Confectioners Publishing Co. of Glen Rock, N.J.

Corrosion inhibitors may also be optionally added to provide protection to the copper lines during the cleaning process. The compositions of the present disclosure can also optionally contain up to about 15% by weight, or about 0.2 to about 10% by weight of a corrosion inhibitor. Any corrosion inhibitor known in the art for similar applications, such as those disclosed in U.S. Pat. No. 5,417,877 may be used. Corrosion inhibitors may be, for example, an organic acid, an organic acid salt, a phenol, a triazole, a hydroxylamine or acid salt thereof. Examples of particular corrosion inhibitors include anthranilic acid, gallic acid, benzoic acid, isophthalic acid, maleic acid, fumaric acid, D,L-malic acid, malonic acid, phthalic acid, maleic anhydride, phthalic anhydride, benzotriazole (BZT), resorcinol, carboxybenzotriazole, diethyl hydroxylamine and the lactic acid and citric acid salts thereof, and the like. Further examples of corrosion inhibitors that may be used include catechol, pyrogallol, and esters of gallic acid. Particular hydroxylamines that can be used include diethylhydroxylamine and the lactic acid and citric acid salts thereof. Yet other examples of suitable corrosion inhibitors include fructose, ammonium thiosulfate, glycine, lactic acid, tetramethylguanidine, iminodiacetic acid, and dimethylacetoacetamide. In certain embodiments, the corrosion inhibitor may include a weak acid having a pH ranging from about 4 to about 7. Examples of weak acids include trihydroxybenzene, dihydroxybenzene, and/or salicylhydroxamic acid.

The composition may also include one or more of the following additives: chemical modifiers, dyes, biocides, preservatives, and other additives. The additive(s) may be added to the extent that they do not adversely affect the pH range of the composition.

The composition described herein may be prepared by mixing the plurality of chelating agents with water, organic base, and other ingredients such as surfactant, corrosion inhibitor, and/or additives if added. In certain embodiments, the ingredients used in cleaning composition described herein may be purified individually or as a composition consisting of two or more components using ion exchange methods to reduce trace metal ion contamination. In certain embodiments, the mixing may be done at a temperature range of about 40 to 60°C to affect dissolution of the ingredients contained therein. In embodiments containing certain chelating acids such as EDTA, the solubility is very low in water. In these embodiments, it may thus be desirable to dissolve these acids in a solution containing the organic base first prior to adding the other components. The resulting composition may optionally be filtered to remove any undissolved particles that could potentially harm the substrate.

In an alternative embodiment, a concentrated composition comprising the plurality of chelating agents, organic base, optional surfactant, and optional corrosion inhibitor is provided that may be diluted in water to provide the composition. A concentrated composition of the invention, or "concentrate" allows one to dilute the concentrate to the desired strength and pH. A concentrate also permits longer shelf life and easier shipping and storage of the product.

The process composition is preferably used to treat the surface of a substrate after the CMP step. Suitable substrates include, but are not limited to, semiconductor materials such as gallium arsenide ("GaAs"), boronitride ("BN") silicon, and compositions containing silicon such as crystalline silicon, polysilicon, amorphous silicon, epitaxial silicon, silicon dioxide ("SiO₂"), silicon carbide ("SiC"), silicon oxycarbide ("SiOC"), silicon nitride ("SiN"), silicon carbonitride ("SiCN"), organosilica glasses ("OSG"), organofluorosilicate glasses ("OFSG"), fluorosilicate glasses ("FSG"), and other appropriate substrates or mixtures thereof. Substrates may further comprise a variety of layers to which the metal material such as copper is applied thereto such as, for example, diffusion barrier layers (e.g., TiN, Ti(C)N, TaN, Ta(C)N, Ta, W, WN, TiSiN, TaSiN, SiCN, TiSiCN, TaSiCN, or W(C)N), antireflective coatings, photoresists, organic polymers, porous organic, inorganic materials, low dielectric constant materials, high dielectric constant materials, and additional metal layers. Further exemplary substrates include silicon, aluminum, or polymeric resins.

The method described herein may be conducted by contacting a substrate having post-CMP processing residues such as, for example, abrasive particles, processing residues, oxides, metallic ions, salts, or complex or combination thereof present as a film or particulate residue, with the described composition. Method of cleaning may involve scrubbing of the wafer with polymeric brushes in a fluid medium consisting of cleaning chemistry and water. Another method to clean wafer surface may involve spraying the wafer surface with cleaning chemistry at high velocities. Still another method to clean is to immerse the wafer in bath of cleaning chemistry and impart megasonic energy using a suitable transducer. Typical time periods for exposure of the substrate to the composition may range from, for example, 0.1 to 60 minutes, or 1 to 30 minutes, or 1 to 15 minutes. After contact with the composition, the substrate may be rinsed and then dried. In certain embodiments, a deionized water rinse or rinse containing deionized water with other additives may be employed before, during, and/or after contacting the substrate with the composition described herein. Drying is typically carried out under an inert atmosphere. In alternative embodiments, drying may also be carried out in an atmosphere containing certain concentration of volatile solvents such as isopropyl alcohol in order to minimize defect formation during drying.

The following examples are provided to further illustrate the composition and method disclosed herein.

### EXAMPLES

Unless otherwise specified, all examples were conducted on eight-inch silicon wafers containing an electroplated copper surface film were polished using a Speed-FAM IPEC 472 CMP system, using the CMP slurry CP3210 (manufactured by Air Products and Chemicals Inc.) and diluted with 30% hydrogen peroxide in 100:4 ratio, at 0.14 bar (2 pounds per square inch (psi)) pressure and a 50 revolutions per minute (RPM) table speed for 30 seconds to remove any native products from the copper surfaces. In Tables I and II, all amounts are given in weight percent and add up to 100 weight percent.

### Example 1:

Five hundred gram solutions of exemplary compositions 1 through 5 were formulated using the following ingredients: 8.62 grams of 28.91 % purified citric acid solution supplied by Air Products and Chemicals, Inc. of Allentown, PA; 5.0 grams of a 50% gluconic acid solution obtained from Acros Organics; 2.5 grams of EDTA powder from Acros Organics; 28.70 grams, 29.00 grams, 29.55 grams, 30.11 grams, and 30.88 grams, respectively, of a 25.16% TMAH solution from Sachem Chemicals; and the balance water. The compositions disclosed herein were prepared by mixing the ingredients together in a vessel at room temperature until all solids have dissolved.

**Table I**

| Example | Citric Acid | Gluconic Acid | EDTA | TMAH | Water | pH |
|---|---|---|---|---|---|---|
| Ex. 1 * | 0.5 % | 0.5 % | 0.5% | 1.44% | 97.06% | 8.93 |
| EX. 2 | 0.5 % | 0.5 % | 0.5% | 1.46% | 97.04% | 9.51 |
| Ex. 3 | 0.5 % | 0.5 % | 0.5% | 1.49% | 97.01 % | 10 |
| Ex. 4 | 0.5 % | 0.5 % | 0.5% | 1.52% | 96.99% | 10.61 |
| Ex. 5 | 0.5 % | 0.5 % | 0.5% | 1.55% | 96.95% | 10.92 |

| | | | | | | |
|---|---|---|---|---|---|---|
| * Comparative sample | | | | | | |

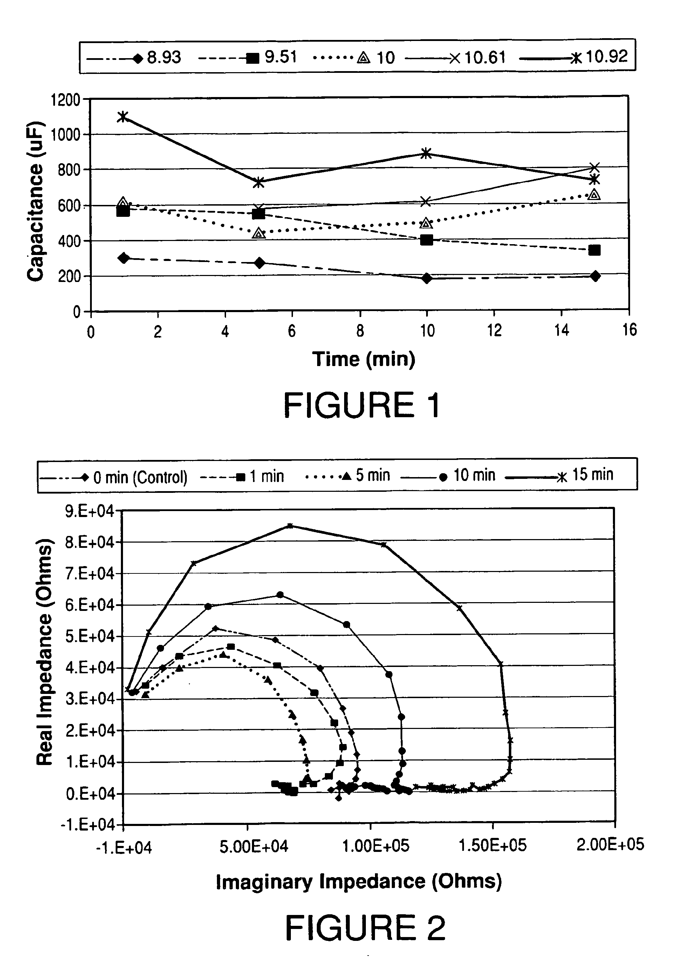

The polished wafers were used as working electrodes in a Gamry paint cell for the purpose of in-situ oxidation monitoring. The cell was filled with the exemplary compositions provided listed in Table I. A Gamry PCI4 computer controlled Potentiostat/Galvanostat was used to monitor oxide growth using electrochemical impedance spectroscopy. Such measurements were carried out at approximately 1 minute, 5 minutes, 10 minutes and 15 minutes after the cell was filled with the exemplary composition. The electrochemical impedance curves obtained were curve-fitted to obtain the capacitance of the copper-electrolyte interface. A lower capacitance is indicative of good protection of the copper surface possibly as a result of a protective oxide formation on the surface. The results of the curve fitting are provided in Figure 1. Capacitance at pH of 8.93 and 9.51 is lowest thereby indicating that oxides may be protective and Cu₂O may be forming on the surface. At higher pH levels, the capacitance is higher indicating either a lower thickness of oxide or a defective oxide. A composition having a pH of around 10.5 may be optimal for certain applications, providing minimal growth of oxides

### Example 2

The effect of cleaning chemistry on oxidiation was studied ex-situ. Like in Example 1, exemplary post-CMP polished wafers were immersed in exemplary composition 4 for 1, 5, 10 and 15 minutes. After drying in a spin-rinse-dryer, these wafers were used as working electrodes in Gamry paint cell for the purpose of oxidation monitoring. The cell was filled with water. Gamry PC14 computer controlled Potentiostat/Galvanostat was used to monitor oxide growth using electrochemical impedance spectroscopy. Such measurements were carried out approximately 1 minute after the cell was filled with water. Figure 2 shows the impedance curves obtained for exemplary composition 4 as a function of time. Figure 2 also provides data on a comparative or "control" sample, which was CMP polished and not treated with the composition.

After treatment with exemplary composition 4, the oxidation level after 1 minute and 5 minutes may be somewhat lower compared to the comparative samples. At the very least, this suggests that the exemplary cleaning composition does not cause a severe oxidation issue in the first 5 minutes of exposure.

### Example 3:

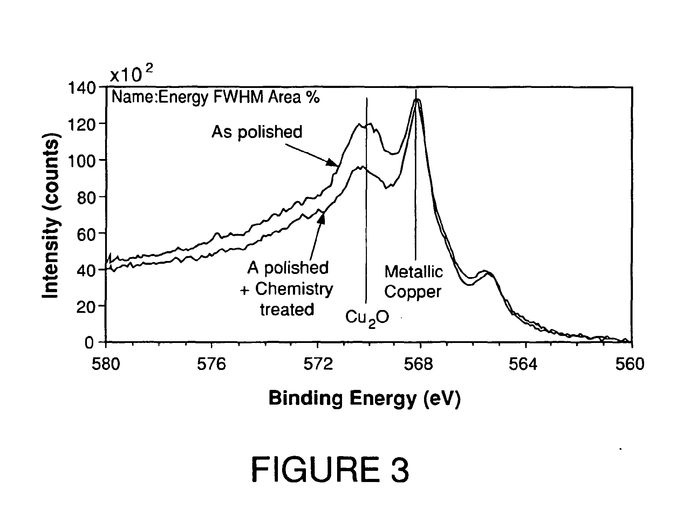

A 1,000 gram solution of exemplary composition 6 was prepared by mixing the following ingredients together in a vessel at room temperature until all solids have dissolved: 172.95 grams of a 28.91 % solution of citric acid; 100.00 grams of a 50% solution of gluconic acid; 50 grams of EDTA; 597.32 grams of a 25.16% solution of TMAH; 9.35 grams of a 10.74% solution of purified HOSTAPUR SAS surfactant (available from Ultra Chemicals) and 7.04 grams of water. Table I provides the weight percent amounts of the ingredients in exemplary composition 6. Electrochemical impedance spectroscopy (ESCA) was used to confirm the absence of oxidation of copper surface after exposure to the cleaning composition. A post-CMP polished wafer was diced into approximately 0.8 cm by 1.3 cm pieces. One of the pieces was immersed for 1 minute in a stirred bath chemistry formed by 10:1 dilution with DI water of the chemistry described in Table II. The sample was rinsed subsequently in DI water for 10 seconds and dried using a nitrogen spray. This sample as well, as a comparative CMP polished sample which was not treated with the composition, was analyzed using X-ray Photoelectron Spectroscopy (XPS). During the analysis, an X-ray induced Cu-LMM peak is known to provide good resolution between metallic copper and its various oxide and hydroxide forms. Figure 3 compares the X-ray induced Auger electron peaks for the comparative sample and the composition-treated sample. This figure clearly shows a lower level of copper oxide on the chemistry treated samples compared to the comparative sample. This may indicate ability to dissolve the copper oxides from the surface.

**Table II**

| Citric Acid | Gluconic Acid | EDTA | TMAH | Surfactant | Water | pH |
|---|---|---|---|---|---|---|
| 5% | 5% | 5% | 15% | 0.1% | 69.9% | 10.50 |

### Example 4:

An eight inch patterned wafer having a Sematech 854 pattern with copper structures within BLACK DIAMOND™ (available from Applied Materials Inc.) was polished for 5 minutes on a IC1000 (available from Rohm & Hass Electronic Materials) CMP pad with a Air Products CP3210 (diluted with 30% hydrogen peroxide in volume ratio 100:4) using a IPEC 372 polisher tool to remove copper from the surface. Polish pressure for this step was 0.19 bar (2.8 psi) and platen speed was 90 RPM. The wafer was then polished for 1 minute at 3 psi polishing pressure and 90 RPM table speed on POLITEX™ Supreme (available from Rohm and Hass Electonic Materials) pad with Air Products CP4110A slurry (diluted with 30% hydrogen peroxide in 9:1 ratio by volume). The wafers were cleaned on ONTRAK™ Synergy (available from Lam Research Corp.) cleaner. This tool consisted of two brush stations consisting of poly vinyl alcohol brushes. Wafers were cleaned on each brush stations for a total of 45 seconds which included 5 seconds of cleaning chemistry dispense time and 40 seconds of rinsing with DI water. In addition the brushes were continuously wetted with a low flow of DI water.

Exemplary composition 6 was used for cleaning the wafers. A comparative sample was run by cleaning with deionized (DI) water only. Defects were analyzed with using ORBOT™ Duo 736 metrology tool (available from Orbot Systems). Table III compares the number of defects in different defect categories after cleaning with and without exemplary composition 6 dispensed in the brush stations. Table III illustrates that treatment with exemplary composition 6 reduced the number of defects on the wafer compared to deionized water alone.

**Table III**

| Defect Classification | Treatment with Exemplary Composition 6 | Treatment with DI Water only |
|---|---|---|
| Particles | 7 | 67 |
| Film Residues | 2 | 0 |
| Defects not related to Cleaning | 25 | 31 |
| Water marks | 0 | 3 |
| Corrosion | 1 | 3 |

## Claims

1. A composition for cleaning a substrate after chemical mechanical processing comprising: water, an organic base comprising a quaternary ammonium hydroxide, and a plurality of chelating agents comprising an amino polycarboxylic acid and a hydroxyl carboxylic acid, wherein the pH of the composition ranges from 9.5 to 11.5.

2. The composition of claim 1 further comprising a corrosion inhibitor.

3. The composition of claim 2 wherein the corrosion inhibitor is selected from anthranilic acid, gallic acid, benzoic acid, malonic acid, maleic acid, fumaric acid, D,L-malic acid, isophthalic acid, phthalic acid, lactic acid, maleic anhydride, phthalic anhydride, catechol, pyrogallol, esters of gallic acid, benzotriazole, carboxybenzotriazole, fructose, ammonium thiosulfate, glycine, tetramethylguanidine, iminodiacetic acid, dimethylacetoacetamide, thioglycerol, trihydroxybenzene, dihydroxybenzene, salicyclhydroxamic, and mixtures thereof.

4. The composition of claim 1 further comprising a surfactant.

5. The composition of claim 1 wherein the amino polycarboxylic acid is selected from ethylene diamine tetra acetic acid, n-hydroxy ethylene diamine triacetic acid, diethylene triamine pentaacetic acid, nitrili triacetic acid, and salts and mixtures thereof.

6. The composition of claim 5 wherein the amino polycarboxylic acid comprises ethylene diamine tetra acetic acid.

7. The composition of claim 1 wherein the hydroxyl carboxylic acid is selected from citric acid, gluconic acid, malic acid, tartaric acid, lactic acid, and salts and mixtures thereof.

8. The composition of claim 7 wherein the hydroxyl carboxylic acid comprises citric acid and gluconic acid.

9. The composition of claim 1 wherein the quaternary ammonium hydroxide comprises tetramethyl ammonium hydroxide.

10. A method for removing residues from a substrate that was CMP-processed comprising: contacting the substrate with a composition comprising: water, an organic base, a plurality of chelating agents comprising an amino polycarboxylic acid and a hydroxyl carboxylic acid wherein the composition has a pH ranging from 9.5 to 11.5.

11. A composition for removing residue from a substrate that was CMP-processed wherein the composition has a pH ranging from 9.5 to 11.5, the composition comprising:
a plurality of chelating agents comprising an amino polycarboxylic acid and a hydroxyl carboxylic acid;
an organic base;
a surfactant;
optionally a corrosion inhibitor; and
water.

12. The composition of claim 11 wherein the organic base comprises a quaternary ammonium hydroxide.

## Patentansprüche

1. Zusammensetzung zum Reinigen eines Substrats nach einer chemisch-mechanischen Behandlung, die folgendes umfaßt:
Wasser, eine organische Base, die ein quaternäres Ammoniumhydroxid umfaßt, und eine Vielzahl von Chelatbildnern, die eine
Aminopolycarbonsäure und eine Hydroxycarbonsäure umfassen,
wobei der pH-Wert der Zusammensetzung im Bereich von 9,5 bis 11,5 liegt.

2. Zusammensetzung nach Anspruch 1, die ferner einen Korrosionsinhibitor umfaßt.

3. Zusammensetzung nach Anspruch 2, wobei der Korrosionsinhibitor ausgewählt ist aus: Anthranilsäure, Gallsäure, Benzoesäure, Malonsäure, Maleinsäure, Fumarsäure, D,L-Äpfelsäure, Isophthalsäure, Phthalsäure, Milchsäure, Maleinsäureanhydrid, Phthalsäureanhydrid, Catechin, Pyrogallol, Estern von Gallsäure, Benzotriazol Carboxybenzotriazol, Fructose, Ammoniumthiosulfat, Glycin, Tetramethylguanidin, Iminodiessigsäure, Dimethylacetoacetamid, Thioglycerol, Trihydroxybenzol, Dihydroxybenzol, Salicyclhydroxam (salicyclhydroxamic) und Gemischen davon.

4. Zusammensetzung nach Anspruch 1, die ferner ein oberflächenaktives Mittel umfaßt.

5. Zusammensetzung nach Anspruch 1, wobei die Aminopolycarbonsäure aus Ethylendiamintretaessigsäure, n-Hydroxyethylendiamintriessigsäure, Diethylentriaminpentaessigsäure, Nitrilotriessigsäure und Salzen und Gemischen davon ausgewählt ist.

6. Zusammensetzung nach Anspruch 5, wobei die Aminopolycarbonsäure Ethylendiamintetraessigsäure umfaßt.

7. Zusammensetzung nach Anspruch 1, wobei die Hydroxycarbonsäure aus Citronensäure, Gluconsäure, Äpfelsäure, Weinsäure, Milchsäure und Salzen und Gemischen davon ausgewählt ist.

8. Zusammensetzung nach Anspruch 7, wobei die Hydroxycarbonsäure Citronensäure und Gluconsäure umfaßt.

9. Zusammensetzung nach Anspruch 1, wobei das quaternäre Ammoniumhydroxid Tetramethylammoniumhydroxid umfaßt.

10. Verfahren zum Entfernen von Rückständen von einem Substrat, das durch CMP behandelt worden ist, umfassend:
Kontakt des Substrats mit einer Zusammensetzung, die Wasser, eine organische Base, eine Vielzahl von Chelatbildnern, die eine Aminopolycarbonsäure und eine Hydroxycarbonsäure umfassen, aufweist, wobei die Zusammensetzung einen pH-Wert im Bereich von 9,5 bis 11,5 hat.

11. Zusammensetzung zum Entfernen eines Rückstands von einem Substrat, das durch CMP behandelt worden ist, wobei die Zusammensetzung einen pH-Wert im Bereich von 9,5 bis 11,5 hat, wobei die Zusammensetzung folgendes aufweist:
eine Vielzahl von Chelatbildnern, die eine Aminopolycarbonsäure und eine Hydroxycarbonsäure umfassen,
eine organische Base,
ein oberflächenaktives Mittel,
gegebenenfalls einen Korrosionsinhibitor und
Wasser.

12. Zusammensetzung nach Anspruch 11, wobei die organische Base ein quaternäres Ammoniumhydroxid umfaßt.

## Revendications

1. Composition de nettoyage d'un substrat après traitement chimico-mécanique comprenant : de l'eau, une base organique comprenant un hydroxyde d'ammonium quaternaire et une pluralité d'agents chélateurs comprenant un acide amino polycarboxylique et un acide carboxylique hydroxylé, dans laquelle le pH de la composition va de 9,5 à 11,5.

2. Composition selon la revendication 1 comprenant en outre un inhibiteur de corrosion.

3. Composition selon la revendication 2 dans laquelle l'inhibiteur de corrosion est choisi parmi l'acide anthranilique, l'acide gallique, l'acide benzoïque, l'acide malonique, l'acide maléique, l'acide fumarique, l'acide D,L-malique, l'acide isophtalique, l'acide phtalique, l'acide lactique, l'anhydride maléique, l'anhydride phtalique, le catéchol, le pyrogallol, les esters de l'acide gallique, le benzotriazole, le carboxybenzotriazole, le fructose, le thiosulfate d'ammonium, la glycine, la tétraméthylguanidine, l'acide iminodiacétique, le diméthylacétoacétamide, le thioglycérol, le trihydroxybenzène, le dihydroxybenzène, l'acide salicylhydroxamique, et leurs mélanges.

4. Composition selon la revendication 1 comprenant en outre un tensioactif.

5. Composition selon la revendication 1 dans laquelle l'acide amino polycarboxylique est choisi parmi l'acide éthylènediaminetétraacétique, l'acide N-hydroxyéthylènediaminetriacétique, l'acide diéthylènetriaminepentaacétique, l'acide nitrilotriacétique, et leurs sels et leurs mélanges.

6. Composition selon la revendication 5 dans laquelle l'acide amino polycarboxylique comprend l'acide éthylènediaminetétraacétique.

7. Composition selon la revendication 1 dans laquelle l'acide carboxylique hydroxylé est choisi parmi l'acide citrique, l'acide gluconique, l'acide malique, l'acide tartrique, l'acide lactique, et leurs sels et leurs mélanges.

8. Composition selon la revendication 7 dans laquelle l'acide carboxylique hydroxylé comprend l'acide citrique et l'acide gluconique.

9. Composition selon la revendication 1 dans laquelle l'hydroxyde d'ammonium quaternaire comprend l'hydroxyde de tétraméthylammonium.

10. Procédé d'élimination de résidus sur un substrat qui a été traité par CMP comprenant :
la mise en contact du substrat avec une composition comprenant : de l'eau, une base organique, une pluralité d'agents chélateurs comprenant un acide amino polycarboxylique et un acide carboxylique hydroxylé, dans lequel la composition a un pH allant de 9,5 à 11,5.

11. Composition pour éliminer un résidu sur un substrat qui a été traité par CMP dans laquelle la composition a un pH allant de 9,5 à 11,5, la composition comprenant :
une pluralité d'agents chélateurs comprenant un acide amino polycarboxylique et un acide carboxylique hydroxylé ;
une base organique ;
un tensioactif ;
éventuellement un inhibiteur de corrosion ; et
de l'eau.

12. Composition selon la revendication 11 dans laquelle la base organique comprend un hydroxyde d'ammonium quaternaire.
